# EUROPEAN PATENT SPECIFICATION

(11) **EP 1 513 021 B1**
(45) Date of publication and mention of the grant of the patent: **03.10.2007**
(21) Application number: 04077409.3
(22) Date of filing: 26.08.2004
(51) Int. Cl.: G03F 7/20, G02B 7/00

(54) **Lithographic apparatus and a method of compensating for thermal deformation in a lithographic apparatus**
Lithographischer Apparat und Methode zur Kompensation von thermischer Deformation in einem lithographischen Apparat
Appareil lithographique et méthode de compensation de déformation thermique dans un appareil lithographique

(30) Priority: 04.09.2003 EP 03077784
(43) Date of publication of application: 09.03.2005
(73) Proprietor: ASML Netherlands B.V., 5504 DR Veldhoven (NL)
(72) Inventor: Franken, Dominicus J. P. A., 5508 JA Veldhoven (NL); Box, Wilhelmus J., 3941 Eksel (BE)
(74) Representative: Winckels, Johannes Hubertus F.

(56) References cited:
- EP-A- 0 678 768
- DE-A- 3 803 738
- GB-A- 2 321 316
- US-A- 5 581 324

## Description

The present invention relates to a lithographic apparatus and a method of compensating for thermal deformation in a lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

A lithographic apparatus includes components, such as radiation sources, that generate heat. Other elements in the lithographic apparatus, such as support frames and optical and other elements are subject to a thermal load from the heat generating components. It has been found that the thermal loads experienced by certain elements in the lithographic apparatuses compromises the imaging quality of the apparatus. It is an object of the present invention to address this problem.

Further, to reduce the size of features that can be imaged using a lithographic apparatus, it is desirable to reduce the wavelength of the illumination radiation. Ultraviolet wavelengths of less than 180nm are therefore currently used, for example 157nm or 126nm. Also used are extreme ultraviolet (EUV), also referred to as soft x-rays, wavelengths of less than 50nm, for example 13.5nm.

A consequence of using shorter wavelengths is that whilst thermal stability within the projection system continues to be a problem in lithographic apparatuses, it has been found that apparatuses operating at shorter wavelengths, such as those less than 180nm, are even more prone to thermal stability problems than those operating at higher wavelengths.

An apparatus operating at a shorter wavelength, for example, is described in our pending European patent application No. 1178357. In EP1178357 a lithographic apparatus is known of which certain components are located in a vacuum chamber. The projection beam images the mask onto the substrate via a number of mirrors. Such an arrangement is needed for example when an EUV beam is used, because an EUV projection beam would be unsuitable for projection purposes in gases at atmospheric pressure, and because no refractive optical elements are presently available for EUV radiation. The same arrangements are necessary for other types of beams.

European Patent Application No. 1178357 notes that operation under vacuum can cause temperature stability problems, because heat radiation from the walls of the vacuum chamber or from the vacuum pump could lead to thermal expansion or contraction. This results in imaging errors when temperature critical components like the reference frame including the support frame, the substrate table or the projection system.

In particular, thermal stability affects the imaging quality because the position of the optical elements, in particular, the mirrors in EUV lithography projection apparatuses, needs to be achieved and maintained during the exposure extremely accurately. For example, in EUV apparatuses, the mirrors need to be positioned with an accuracy of +/- 0.1 nm or less. Since the optical elements, such as mirrors, are supported on a support frame, it will be understood that temperature variations which cause the support frame to deform may also cause the position of the mirrors to vary.

Conventionally, this problem has been addressed by designing apparatuses so that they react as little as possible to thermal variations. For example, by constructing support frames and other critical structures of materials such as Zerodur (trademark) or invar, which are specialist materials referred to in the art as NZTE (near-zero thermal expansion) materials or the like. Such materials are designed to have very low expansion coefficients. Although the use of these materials improves the thermomechanicalstability of the apparatus, they have various drawbacks including cost, manufacturability and fragility of the materials used, such as Zerodur, add to the complexity of the manufacture. Also, connecting glass materials together is problematic, which is one of the factors contributing to the more general problem of manufacturability of NZTE materials, such as Zerodur.

A further approach to solving the problem of thermal stability, as for example, described in EP1178357, is to provide a heat shield disposed between heat sources and temperature critical components. A further approach is disclosed in US 5,581,324.

It has been found that in spite of efforts to minimize the effect temperature fluctuations have on the lithographic apparatus operating at any wavelength, this impact cannot be fully eliminated. Further as mentioned above, the materials and techniques used to combat the problem of thermal stability, have their drawbacks generally adding to the complexity and to the cost of the apparatus.

It is an object of the present invention to address the problems encountered in conventional apparatuses with respect to thermomechanial stability. It is a further object of the present invention to provide an apparatus wherein the position of at least one moveable optical element in the projection system is thermomechanically stable.

According to an aspect of the present invention, there is provided a lithographic apparatus according to claim 1.
By sensing the temperature at at least one location, it is possible to compensate for thermal deformation of the element. By providing a deformation compensation unit to compensate, rather than attempt to eliminate deformation of the element caused by temperature fluctuations, it is no longer necessary to manufacture elements in the lithographic apparatus that arc subject to a thermal load out of specialist materials, such as an NZTE material, such as Zerodur. Instead, cheaper, less fragile and more easily manufacturable materials can be used. This provides the advantages of reducing the material and manufacturing cost and increasing the manufacturability of certain elements in the lithographic apparatus that are subject to a thermal load. As a result, when compensating for a thermal load on a projection system support frame, the thermal stability is improved so that a positioning accuracy of the moveable optical element supported by the projection system support frame of a fraction of a nanometre over a period of an exposure is achieved, for example, over several minutes. By providing a control unit, a direct control loop between the element subject to a thermal load and the temperature sensed at the element is established.

In a preferred embodiment, a modelling unit is provided which generates the model using finite element modelling. It has been found that finite element modelling can be used to effectively and accurately model elements made of a homogeneous material, such as Zerodur or a metal, for example, Invar or aluminium. In an alternative embodiment, the deformation of the structure is measured for several temperature distributions and an experimental fit is used to create the model for the thermal deformation compensation unit.

In a preferred embodiment, the at least one temperature sensor is disposed directly on the element. By disposing the at least one temperature sensor directly on the element, the accuracy of the sensed temperature and thus, the compensation of any thermal load is more accurately sensed and compensated for, respectively.

In a preferred embodiment, the at least one temperature sensor is disposed on at least one of an inside and an outside of the element. By disposing the at least one temperatures sensor on at least one of an inside and an outside of the element, the accuracy of the sensed temperature of the element, and thus, the compensation of any thermal load is even more accurately sensed and compensated for, respectively.

The element is a support frame. By compensating for thermal deformations in a support frame, whereas previously, such support frames were necessarily made of expensive, specialist materials, in accordance with the present invention, other cheaper materials, such as metals, such as Invar and aluminium, may be used as materials for a support frame. By providing a support frame of a metal such as Invar or aluminium, benefits in the field of dynamics are obtained, the frame is less fragile, the manufacturability of the support frame is improved, the connection technology, that is the ability to be able to connect different components to one another is simplified, and the freedom to design the support frame is increased. Further, the cost and the lead time of the frame are reduced. Further, it has been found that homogeneous materials, such as metals, can be accurately and effectively modelled using finite element modelling according to a further embodiment of the present invention.

In a preferred embodiment, the support frame is at least one of a source frame for supporting a source of radiation, an illuminator frame for supporting an illumination system, a patterning means support frame for supporting a patterning means, a projection system support frame for supporting a projection system, a first reference support frame for supporting at least one of the projection system support frame and a measurement system, a second reference support frame for supporting the first reference support frame and a substrate support frame for supporting a substrate. In this way, the present invention has application to various elements in the lithographic apparatus.

In a preferred embodiment, a further element is at least one of an optical element and an element comprised in a measuring system. In this way, in addition to support frames, the present invention may be applied to optical elements such as mirrors and lenses and elements in a measuring system, such as mirror blocks.

In a preferred embodiment, the further element is a moveable optical element supported on the support frame, and the control signal causes the position of the further moveable optical element to be adjusted so as to compensate for the deformation of the element, in response to the at least one temperature sensed by said at least one sensor. In this way, rather than having to ensure that the support frame deforms a minimum amount, account for any deformation can be made by the optical elements. Thus, the manufacturing tolerances are reduced. At the same time, the accuracy of the system, for example, the illumination system or projection system, in which the moveable optical elements are disposed is improved.

In a preferred embodiment, at least one temperature sensor is directly disposed on the support frame and the optical element, wherein the position of the optical element is determined by the temperatures sensed by the temperature sensors disposed on the support frame and the optical element. By measuring the temperature directly on the support frame and the optical element, the accuracy of the compensation for the thermal deformation of the structure is further improved.

In a preferred embodiment, the processing unit, responsive to the sensor, provides a deformation signal indicative of the deformation, wherein the processing unit derives the deformation signal on the basis of deformation data and the sensed temperature, wherein the deformation data is derived from the model and represents the deformation of the frame as a function of temperature at the at least one location. By providing a deformation signal derived from the sensed temperature and deformation data, an accurate assessment of the deformation is achievable, which provides an accurately determined deformation signal to the adjustment unit.

In a preferred embodiment, the apparatus comprises: at least one of an illumination system for providing a projection beam of radiation, a support structure for supporting patterning means, the patterning means serving to impart the projection beam with a pattern in its cross-section, a substrate table for holding a substrate and a projection system for projecting the patterned beam onto a target portion of the substrate.

In a preferred embodiment, said deformation data is in the form of a thermal deformation model. By providing the deformation data in the form of a thermal deformation model, deformation data can be provided relating to several parameters and operating conditions of the apparatus. Thus, further increasing the accuracy with which deformation of the support frame can be compensated for.

In a preferred embodiment, the thermal compensation deformation unit compensates for a thermal effect on a structure of the element. In this way, the thermal effect of the structure itself is compensated for.

In a preferred embodiment, the at least one temperatures sensor is located at locations(s) where the structure of the element has a high stiffness. It has been found that temperature sensors placed at locations where the structure has a high stiffness provide particularly good results, since the temperature at these locations dominates the thermomechanical behaviour of the total structure.

According to a further aspect of the present invention, there is provided a method of compensating for thermal deformation in a lithographic apparatus according to claim 21.

According to a yet further aspect of the present invention, there is provided a user terminal comprising means operable to perform the method of any of claims 21-27.

According to a yet further aspect of the invention, there is provided a computer readable storage medium storing a program which when run on a computer controls the computer to perform the method of any of claims 21-27.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer'' or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 355, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems. The lithographic apparatus may also be of a type of a flat panel display.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts details of a lithographic apparatus including a temperature deformation compensation circuit according to an embodiment of the present invention; and
- Figures 3a and 3b depict a support frame on which a plurality of sensors are disposed.

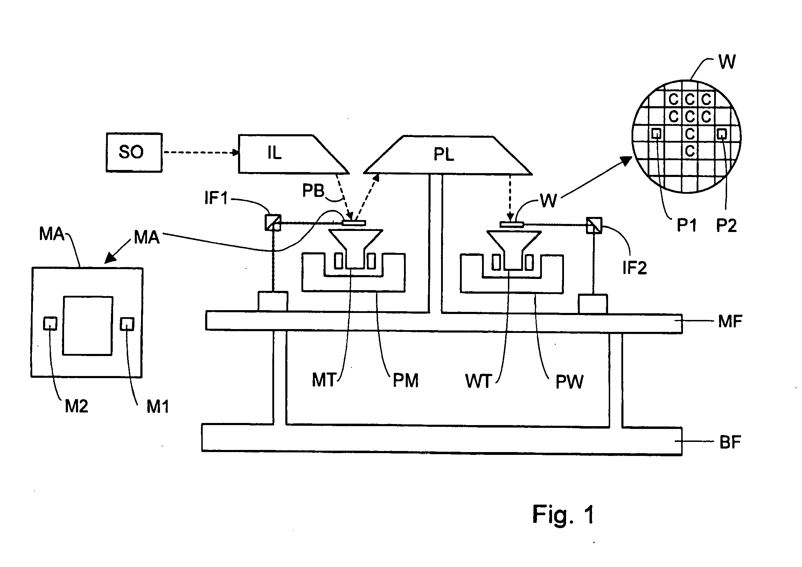

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as an illumination system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

In lithographic apparatuses operating at certain wavelengths, for example, EUV, alpha and gamma radiation, certain apparatus components, for example the projection system, the illuminator, the mask and mask table and the wafer and wafer table, are disposed in a vacuum chamber, which is pumped out using a vacuum pump. Whilst the present invention has particular application to those apparatuses having components in a vacuum chamber because it has been found that the vacuum pump increases the thermal instability of lithographic apparatuses, the present invention also has application to other lithographic apparatuses not comprising a vacuum chamber and pump, since thermal instability continues to be a problem in these apparatuses.

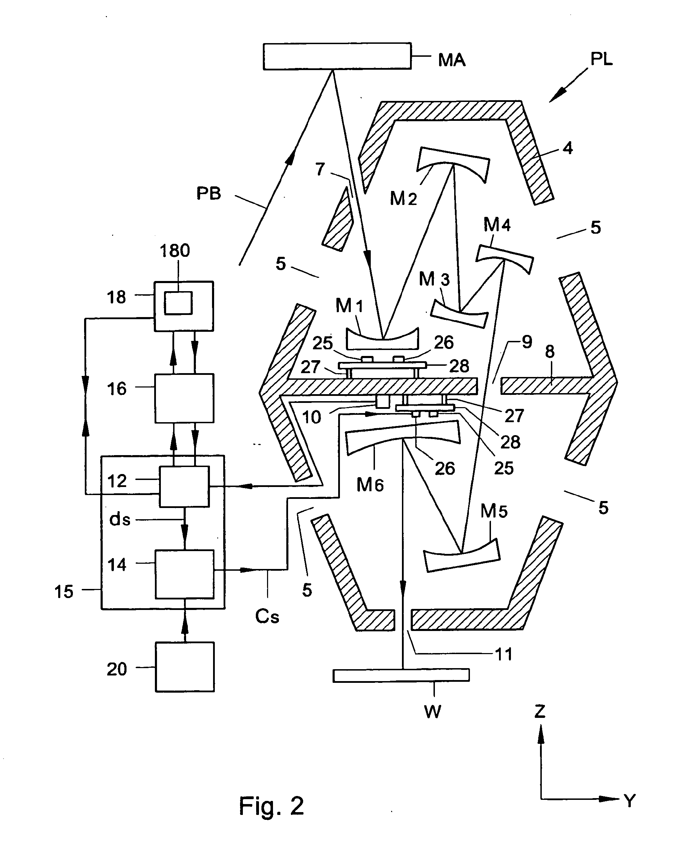

The present invention has application to many elements within a lithographic apparatus. With reference to Figures 2-4, a particular embodiment is described with respect to the compensation of thermal deformation within the projection system is described. However, the invention is not limited in this respect. The invention is applicable to any support frame in the lithographic apparatus, additionally to other elements in a lithographic apparatus, such as optical elements, which may be moveable, such as mirrors and lenses, and also other elements in the measuring systems IF1, IF2, such as the mirror blocks.

For example, elements whose thermal deformations may be compensated for include, but are not limited to a source frame for supporting the source of radiation SO, an illuminator frame for supporting the illumination system IL, a patterning means support frame MT for supporting a patterning means MA, a projection system support frame for supporting a projection system PL, a first reference support frame MF for supporting at least one of the projection system support frame and a measurement system IF1, IF2, a second reference support frame BF for supporting the first reference support frame MF and a substrate support frame WT for supporting a substrate WA. It is noted with respect to the schematic nature of Figure 1, that the support frames recited above, where not indicated specifically in Figure 1, are considered to form a part of the source SO, the illumination system IL, the projection system PL, respectively. As mentioned, by compensating for thermal deformations in elements subject to a thermal load, alternative materials for the elements may be used. For example, at least one of the first reference support frame MF and the second reference support frame BF may be made of at least one of Invar and aluminium. It is noted that in the art, the first reference support frame MF may be referred to as the metrology (or metro) frame and the second reference support frame BF may be referred to as the base frame. In one embodiment, a control signal is output to a further element in the apparatus causing the further element to correct for or take into account the deformation. In a further embodiment, the further element is supported on the element. In a yet further embodiment, the control signal takes into account the deformation in a setpoint for the control of the further element. In a further embodiment, the control signal is output to a further element in the apparatus causing the further element to correct for or take into account the deformation. The further element may be, for example, an optical element, such a mirror or a lens. The further elements may be moveable. In one embodiment, the control signal causes the further element to move in response to the deformation calculated by the thermal deformation compensation unit. As described with reference to Figures 2 to 4, the further element may be supported on the element. Thus, any deformation of the element is compensated for by controlling the further element, by for example, moving the further element to compensate for the deformation of the element. In one embodiment, the control signal takes into account the deformation in a setpoint for the control of the further element.

Figure 2 depicts details of a lithographic apparatus including a temperature deformation compensation circuit according to an embodiment of the present invention. The embodiment of the invention shown in and described with reference Figure 2, is with respect to the projection system PL and the projection system support frame 4. However, as discussed above, the invention is not limited to this example, and may be applied to those further situations described above with reference to Figure 1. For those elements having the same reference numeral as an element shown and described with reference to figure 1, figure 1 is referred to. The projection system PL typically comprises an element 4. The element shown in Figure 2 is a support frame, in particular, the projection system support frame. The projection system PL further comprises a plurality of further elements. In Figure 2, the further elements M1-M6 are a plurality of optical elements M1-M6. The optical elements shown in the embodiment shown in Figure 2 are mirrors. At least one of the mirrors is arranged to be moveable. Typically, all the mirrors except mirror M5 are moveable. The mirrors are arranged to direct the patterned beam from the mask to the wafer. As mentioned, the accuracy with which the mirrors are positioned is extremely high. The position of the mirrors is controlled by control unit 14. A position sensor 25 is provided to determine the position of the mirror. An actuator 26 is adapted to receive a control signal cs from the control unit 14 and causes the mirror to move to a desired position in response to the control signal cs. The mirrors are provided in a support frame 4. The support frame 4 may comprise a reference frame 4 and a plurality of sensor frames 28. The plurality of sensor frames 28 are adapted to be mounted in the reference frame 4 using interfacing elements 27. The sensor frame 28 is a frame adapted to support an optical element M1-M6, typically a moveable mirror, the position sensor 25 and the actuator 26. A separate sensor frame 28 may be provided for each mirror M1-M6. Typically, however, a separate mirror module is provided for M1-M4 and M6. M5 is typically stationary, and mounted directly to the support frame 4. Typically, the mirror M5 is not provided with sensors or actuators. Such a sub-assembly is conventionally referred to as a "mirror module". The mirrors may be in thermal contact with the support frame. In particular, any thermal instability of the support frame affects the optical elements. In Figure 2, for the sake of simplicity only two sensor frames are shown, however, typically all movable mirrors are supported on their own sensor frame 28. Conventionally, each sensor frame 28 is mounted in the reference frame 4 using a so called "statically determined interface" 27. Such an interface may for example, comprise a plurality of elements 27 (of which only a few are shown in figure 2), which are disposed to mount the mirror module in the reference frame 4 in such a way that each element 27 constrains only once each of the six degrees of freedom. In figure 2, the support of the mirrors on the support frame is schematically represented by rods 27 supporting mirrors M1 and M6. Mirrors M2- M4 are typically also supported in a similar way, although for the sake of simplicity in figure 2, the support members are only shown for mirrors M1 and M6. Typically M5 is stationary, thus, its support members differ from those for M1-M4 and M6. Although, the "statically determined interface" as described with reference to figure 2 represents one conventional way of mounting a mirror in a support frame, the present invention is not limited in this respect, and is suitable for application in any apparatus where one moveable optical element is supported on a support frame independent of the nature of the support member. Since the optical elements (mirrors) are supported in the support frame 4, it will be understood that a deformation in the support frame caused by temperature fluctuations in the lithographic apparatus may cause the position of the mirror to change. To address this problem a thermal deformation compensation unit 10, 15 is provided. The thermal deformation compensation unit 10, 15 comprises at least one temperature sensor 10 to sense the temperature at at least one location on the frame 4. In figure 2 one temperature sensor 10 is shown in the vicinity of mirror M6. However, any number of sensors may be provided over the support frame 4. The total number of sensors may be approximately 50, however, this is not limiting. Although, the location of each sensor is not critical to the invention, in a particular embodiment sensors 10 are provided in the vicinity of mirrors M1-M6, in particular in those areas where the sensor frame comes into contact with the reference frame. In alternative embodiments, where the optical elements are mounted in alternative ways in a support frame 4, temperature sensors may be located at those locations where the optical elements are supported on the frame by alternative mounting or supporting elements. For situations where no sensor frames are provided, for example, for embodiments where the mirror position sensors are mounted directly onto the support frame, a temperature sensor is located at the same position as the mirror position sensor, as this position sensor determines the position of the optical element, that is the mirror. Further, sensors may also be disposed at locations where deformation is known to occur, since even deformation at a location relatively remote from an optical element may have an impact on the position of an optical element. In a particular embodiment, it has been found that temperature sensors placed at locations where the structure has a high stiffness provide particularly good results, since the temperature at these locations dominates the thermomechanical behaviour of the total structure. In a particular embodiment, temperature sensors are disposed on both the support frame and the optical elements. In this way, the accuracy of the compensation is further improved. The manner in which the present invention compensates for a given deformation due to the temperature at a particular location is discussed in more detail below.

The support frame 4 provides a frame on which the optical elements M1-M6 are provided. Typically, the support frame 4 is a housing. The projection beam PB enters the housing via an opening or window 7 formed in the housing and leaves the housing via opening or window 11. The housing may also comprise a stiffening plate 8 disposed across the middle of the housing. In this particular embodiment, a further opening or window 9 is provided in the stiffening plate 8 to allow the projection beam to propagate through the housing. The support frame 4 may be made of low expansion materials. However, the invention allows the use of other materials, including metals for the support frame 4. In a particular embodiment, the support frame 4 is comprised of Invar (trademark). The support frame may alternatively be comprised of other metals, such as aluminium or ceramic materials. In general, the invention is independent of the material choice to a large extent.

In order to be able to sufficiently calculate the model for the thermal deformation, the mathematical representation of the thermal properties and behaviour of the material should approximate reality as good as possible. Alternatively, for example, for exotic and or anisotropic materials the thermal deformation model can be determined experimentally, for instance by measuring the deformation of this structure for several temperature distributions and fitting a thermal deformation model in the experimental data, for example, by regression analysis. Also, of course, the temperature measurement should be accurate enough. Various materials are known whose behaviour is more or less linear, i.e. they have thermal expansion coefficients, and thermal conductivity coefficients that are more or less constant in time and as function of the absolute temperature; certainly in the temperature range over which a lithographic apparatus functions, that is from around 20 degrees Celcius to around 30 degrees Celcius. However, in general, even if temperature behaviour is non-linear, provided it is known to a certain degree, deformation can still be predicted accurately enough to be compensated for sufficiently. So, in general, the invention is not limited to materials with linear material properties. However, if material properties are linear, it suffices to measure temperature differences within a certain amount of time, instead of absolute temperatures. Also, materials with high thermal expansion coefficients require a more accurate measurement of temperature changes to be able to achieve that optical image distortion or measurement errors leading to loss of overlay and focus due to finite compensation of deformation of the support frame remains within a certain limit. Thus, in general materials with all kinds of thermal expansion coefficients are allowed. However, the higher that value, the more accurate the measurement of the temperature and or temperature changes are.

With respect to aluminium, it is commented that its coefficient of thermal expansion is quite high, typically 20 to 40 times higher than Invar. Therefore, the amount thermal deformation to be compensated for is increased with respect to an Invar support frame. However, the aluminium provides benefits such as a relatively low cost, easy manufacturability, and robustness, furthermore aluminium has a very high thermal conductivity and specific heat leading to lower and more uniform change in temperatures which again lead to a more uniform deformation and therefore a simpler thermal deformation model. As with Invar, aluminium can exploit well known "connection technology", and there is large scope for design freedom. Further, for aluminium, the ratio of density to Young's Modulus (rho/E) is almost equal to that of Zerodur. The ratio of density to Young's Modulus is a known measure used to determine the difficulty of achieving a desired dynamic behaviour.

In an alternative embodiment a support structure comprising a ceramic material is provided. The choice of ceramic material may be made from various available ceramics. Ceramic materials exhibit a wide range of appropriate properties, such as toughness, coefficient of thermal expansion and conduction and the ratio of density to Young's Modulus (rho/E).

In the embodiments, such as in lithographic apparatuses operating at EUV and other wavelengths, where the projection system PL is disposed in a vacuum chamber, openings 5 are provided in the frame though which a vacuum pump (not shown) evacuates the space enclosed by the support frame 4.

The thermal deformation compensation unit 10, 15 comprises at least one temperature sensor 10 which is disposed on, in or in the vicinity of the support frame 4. The temperature sensor 10 generates a signal indicative of the temperature at a particular location. The temperature sensor 10 is connected to the adjustment unit 15. The adjustment unit 15 includes a processing element such as a processing unit 12 and a control unit 14. The processing unit 12 is part of a control loop including the control unit 14 for generating a control signal cs. Also provided is a storage unit 16 for storing data generated by a modelling unit 18, to which the processing unit 12 has access and a modelling unit 18 for generating data indicative of the deformation at a particular location caused by the temperature at the location, to which the processing unit 12 and the storage unit 16 has access. In addition to receiving data from the processing unit 12, the control unit 14 may also receive input from other control circuits 20 of the lithographic apparatus.

The elements comprised in the control loop may be connected by electrical wires or other elements, such as optical elements including optical fibres or planar waveguides. Alternatively, they may be connected by other elements, such as an IR link, where a line of sight connection is required between the temperature sensor and at least one component of the adjustment unit 15 such as the processing unit 12. Where the control loop elements of the adjustment unit 15 are connected to the temperature sensor or sensors 10 via electrical wires or other means, such as optical fibres, or an IR link, the connection means may be conveniently fed or established through existing openings formed in the support frame 4, such as openings 5. Thus, the mechanical stability of the support frame 4 is not compromised or the manufacture complicated by the formation of additional holes or features in the support frame 4. The data transfer may also take place via other wireless means.

The elements of the control loop including the adjustment unit 15 maybe disposed locally in the lithographic apparatus, or in the vicinity of the lithographic apparatus. Alternatively, they may be disposed at a remote location, for example, at a remote control location. In particular, it is envisaged that the modelling unit 18 and storage unit 16 are disposed at a location remote from the lithographic apparatus. In such an embodiment, the processing unit 12 is adapted to gain remote access to the storage unit 16 and modelling unit 18.

The processing unit 12 is adapted to receive the signal generated by a particular temperature sensor 10. In one embodiment, the signal generated by a particular temperature sensor 10 also includes a component, which identifies the location of the sensed temperature to the processing unit 12. Alternatively, the processing unit 12 includes an addressable memory, which enables a particular sensed temperature to be associated at the processing unit 12 with the particular location for which the sensed temperature is associated. Having identified the location of the sensing and the temperature, the processing unit 12 gains access to storage unit 16. In storage unit 16 data describing the mechanical behaviour of the support frame 4 as a function of temperature is stored, in particular, the storage unit 16 stores the deformation data at a particular location as a function of temperature. For a particular temperature reading at a particular location, in particular, the location or locations where an optical element is either directly or indirectly in contact with the support frame 4, the processing unit 12 calculates the deformation of the frame 4 based on model calculations carried out previously. Thus, the corresponding deformation data for a particular location is obtained. The deformation data is provided to the storage unit 16 by a modelling unit 18. The modelling unit 18, which may also be in direct connection with the processing unit 12, produces a computer generated model of the support frame 4 over its surface as a function of temperature. It has been found that for a construction made from a homogeneous material, such as metal, including Invar and aluminium, can be modelled particularly well using finite element modelling. Thus, depending on the number of sensors, it is possible to calculate the deformation of the support frame 4 as a function of the temperature measured at several places on the inside and the outside of the support frame. Based on the data available to the processing unit 12, the processing unit 12 generates a deformation compensation signal ds, which is indicative of the deformation caused by the sensed temperature at a particular location. The deformation compensation signal dcs is provided to the control unit 14, which in response to the deformation compensation signal, and any other control signals it may receive from other control units 20, generates a control signal cs. The control signal cs generated by control unit 14 thus takes into account any deformation in the setpoint for the position control loops of the optical elements of each "mirror module". The control signal cs is applied to the optical element, for example, via actuator 26, to cause the position of the optical element to be changed in accordance with the control signal cs.

In a particular embodiment, a computer comprising units/elements 12, 14, 15, 16, 18 is provided, containing a mathematical model 180 that describes thermal behaviour of the support frame 4. Using this model 180 it is possible to predict distortion of the frame 4 as a function of either absolute or relative temperatures at a number of positions. Distortion is understood to mean displacement of one frame point with respect to another point. The model 180 is determined, for example, during the design process of the support frame 4 of the projection optics assembly PL. Alternatively, it may comprise a number of values to be supplied and/or adjusted for each support frame 4, or each generation of support frames. It is also envisaged that the model 180 may be fine tuned for each projection box assembly PL. This may be carried out either manually or automatically, during assembly of the exposure unit. It is further envisaged that the fine tuning may be repeated intermittently, for example, every few months, or after an appropriate determined intervals. Again, this fine tuning may be carried out manually or automatically. Automatic tuning, or self-calibration, is possible by measuring actual temperatures of the support frame 4, while at the same time measuring the actual optical image at wafer side, and calculating its distortions, for example, using an interferometric technique.

The input for the model 18 may be absolute or relative temperatures, measured at a plurality of locations by temperature sensors 10. Based on these values, this mathematical model 180 calculates a distortion. The accuracy of the calculated distortion will depend on the accuracy of the mathematical model and the accuracy of the measured temperatures. Using the calculated distortion values, mirror displacements that would have been caused by the distortion are calculated. Then, displacements required by actuators 26 to counteract those mirror displacements are calculated.

Finally, those latter displacements to compensate for, and preferably eliminate mirror displacements from support frame distortions, are executed by actuators 26.

In one particular embodiment adjustment unit 15 comprises the central processing unit (CPU) 12 of a computer and the computer output 14. The storage unit 16 comprises a computer memory. The modelling unit 18 comprises the mathematical model 180 stored in the computer. The other control circuit 20 comprises an external input. As well as the computer being separate from the lithographic apparatus, it is envisaged that the computer does not necessarily comprise a separate computer. In such an embodiment, the computer model 18 and all required software is part of the "machine software". Preferably, the computer uses the SUN computer platform that runs the EUV, TWINSCAN or PAS exposure unit (SUN is a trademark). Alternatively, it may be a dedicated satellite processing unit, of which there are a plurality distributed through the exposure units. This dedicated processing unit with its RAM may be located near the thermal deformation compensated structure, or be part of the thermal deformation compensated structure assembly. Preferably, however, it communicates with the main machine software, receiving e.g. setpoints, instructions, values, timings and data from other units, and uploading loggings, status, calibration results, etc. Access to, and interfacing with the model, its numerical values, its activities, etc. may be carried out using a user interface terminal provided with each exposure unit.

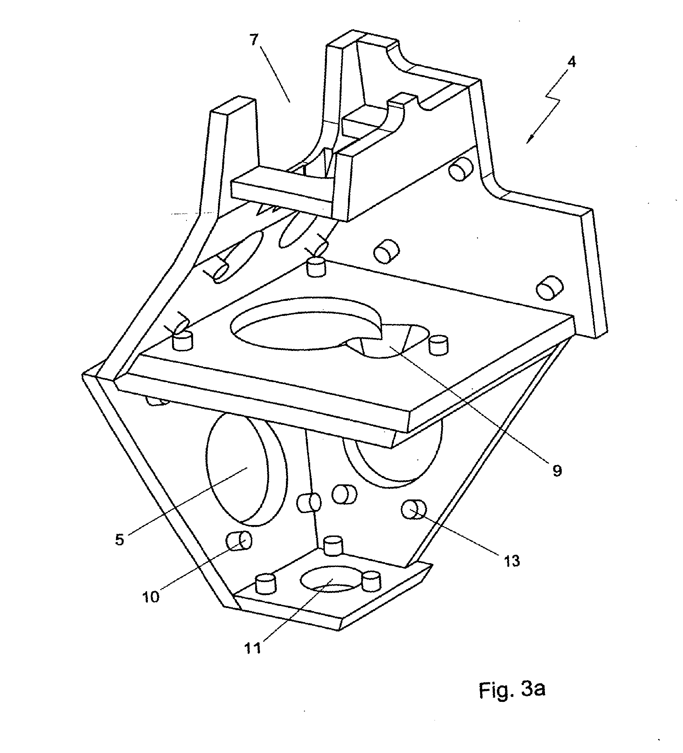

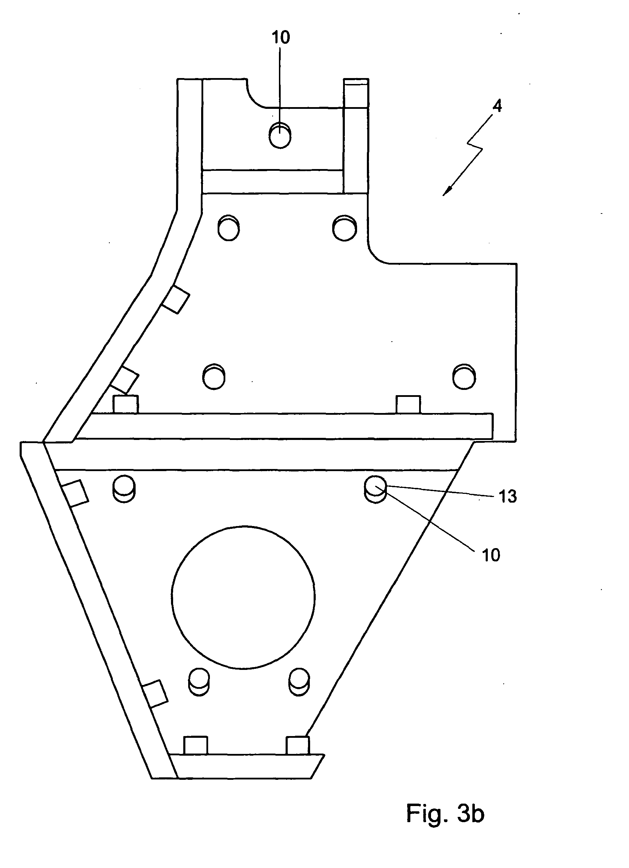

Figures 3a and 3b depict a support frame 4 on which a plurality of temperature sensors 10 are disposed. Figure 3a shows a support frame 4 in three dimensions, wherein the forward facing outer walls of the support frame 4 have been omitted to show the interior of the support frame 4. Figure 3b shows a plan view of one side of the exterior facing wall of the support frame. As mentioned, the temperature sensors 10 may be disposed on the inside or the outside of the support frame 4, or both. Furthermore, the temperature sensors may be located on top of the material but also inside the material since this provides a particularly accurate reading. The distribution of the sensors and their exact numbers are not critical to the invention. However, the greater the number of sensors, the more accurately the deformation can be assessed, and thus compensated for. The sensors 10 used measure temperatures with an resolution of at least 0.1mK and in addition to being suitable to non-vacuum conditions, are suitable for use in those conditions found in evacuated chambers. It is commented that the absolute accuracy of the sensors is not essential. The sensors 10 are small and simple components, which do not add greatly to the complexity of the frame 4 and do not compromise the function or manufacturability of the support frame 4. Optionally, a shield 13 is provided around the sensor to protect it from any effects of the projection beam. Since the projection beam is directed through the frame by mirrors, it is unlikely that any substantial amount of radiation should be incident on the sensors, since the sensors are disposed on the support frame, which is not in the propagation path of the projection beam PB. However, since scatter causes a certain amount of light to be reflected at all angles, the shields protect the sensors from any scattered light.

The deformation compensation processing be carried out at particular time intervals whilst the apparatus is operational. Alternatively, it may be carried out continuously over a particular time duration, for example, during an exposure. It has been found that using the present invention is 90-98% effective in compensating for deformation in the support frame caused by temperature fluctuations, representing a gain factor of 10 to 50. Thus, the thermal demands on the material the frame is made of can be relaxed to an equal extent to achieve at least a comparable thermal stability with conventional frames. Thus, the choice of materials open for consideration for the support frame is greatly increased to, for example, metals such as Invar and other materials, as discussed above.

Whilst specific embodiments of the invention have been described above, it will be appreciated that the invention may be practiced otherwise than as described. The invention is defined by the claims.

## Claims

1. A lithographic apparatus comprising: an element (4) subject to a thermal load, a thermal compensation deformation unit (10, 12, 14, 15) for compensating in the lithographic apparatus for a deformation of the element (4) caused by the thermal load, the thermal compensation deformation unit (10, 12, 14, 15) comprising: at least one temperature sensor (10) for sensing a temperature at at least one location on the element (4), a processing unit (12) for calculating the deformation of the element (4) caused by the thermal load as a function of the temperature sensed at the location, wherein the deformation is calculated using data from a computer generated model of the element (4), so that an appropriate correction can be made or taken into account for the deformation in the lithographic apparatus, **characterised in that** the element (4) is a support frame for supporting a further element (M1-M6).

2. An apparatus according to claim 1, further comprising a modelling unit (18) for generating the model (180) of the element (4).

3. An apparatus according to claim 2, wherein the modelling unit (18) uses the model (180) generated by finite element modelling or by an experimental fit.

4. An apparatus according to any of the preceding claims, wherein the thermal deformation compensation unit (10, 12, 14, 15) further comprises a control unit (14) arranged to output a control signal (cs), in response to the calculated deformation, wherein the control signal (cs) corrects for or takes into account the deformation.

5. An apparatus according to claim 4, wherein the control signal (cs) is output to the further element (M1-M6) in the apparatus causing the further element (M1-M6) to correct for or take into account the deformation.

6. An apparatus according to claim 5, wherein the further element (M1-M6) is supported on the element (4).

7. An apparatus according to any of claims 4-6, wherein the control signal (cs) takes into account the deformation in a setpoint for the control of the further element (M1-M6).

8. An apparatus according to any of the preceding claims, further comprising a storage unit (16) for storing the computer generated model (180).

9. An apparatus according to any of the preceding claims, wherein the at least one temperature sensor (10) is disposed directly on the element (4).

10. An apparatus according to claim 9, wherein the at least one temperature sensor (10) is disposed on at least one of an inside and an outside of the element (4).

11. An apparatus according to claim 1, wherein the support frame (4) is at least one of a source frame for supporting a source of radiation (SO), an illuminator frame for supporting an illumination system (IL), a patterning means support frame for supporting a patterning means(MA), a projection system support frame for supporting a projection system (PL), a first reference support frame(MF) for supporting at least one of the projection system support frame and a measurement system, a second reference support frame (BF) for supporting the first reference support frame and a substrate support frame for supporting a substrate (W).

12. An apparatus according to claim 1, wherein at least one of the first reference support frame (MF) and the second reference support frame (BF) is made of at least one of Invar and aluminium.

13. An apparatus according to any of the preceding claims 1-10, wherein the further element (M1-M6) is at least one of an optical element (M1-M6) and an element comprised in a measuring system (IF).

14. An apparatus according to claim 1 or claim 10, wherein the further element (M1-M6) is a moveable optical element supported on the support frame, and that the control signal (cs) causes the position of the further moveable optical element to be adjusted so as to compensate for the deformation of the element, in response to the at least one temperature sensed by said at least one sensor (10).

15. An apparatus according to claim 14, wherein at least one temperature sensor (10) is directly disposed on the support frame (4) and the optical element (M1-M6), wherein the position of the optical element (M1-M6) is determined by the temperatures sensed by the temperature sensors (10) disposed on the support frame (4) and the optical element (M1-M6).

16. An apparatus according to any of the preceding claims, wherein the processing unit (12), responsive to the sensor (10), provides a deformation signal (ds) indicative of the deformation, wherein the processing unit (12) derives the deformation signal (ds) on the basis of deformation data and the sensed temperature, wherein the deformation data is derived from the model (180) and represents the deformation of the frame (4) as a function of temperature at the at least one location.

17. An apparatus according to any of preceding claims 11-16, wherein the projection system support frame (4) supports a plurality of optical elements (M1-M6) including at least one moveable optical element, the plurality of optical elements (M1-M6) being disposed in the frame (4) in a spaced relationship, wherein the thermal deformation compensation unit (10, 12, 14, 15) comprises an adjustment unit (15) for adjusting the position of at least one of the plurality of moveable elements (M1-M6) in response to the sensed temperature.

18. An apparatus according to any of the preceding claims comprising: at least one of an illumination system (IL) for providing a projection beam of radiation, a support structure (MT) for supporting patterning means (MA), the patterning means (MA) serving to impart the projection beam with a pattern in its cross-section, a substrate table (WT) for holding a substrate (W) and a projection system (PS) for projecting the patterned beam onto a target portion of the substrate (W).

19. An apparatus according to any one of preceding claims, wherein the thermal compensation deformation unit (10, 12, 14, 15) compensates for a thermal effect on a structure of the element (4).

20. An apparatus according to any one of the preceding claims, wherein the at least one temperatures sensor (10) is located at locations(s) where the structure of the element (4) has a high stiffness.

21. A method of compensating for thermal deformation in a lithographic apparatus, said lithographic apparatus comprising an element (4) subject to a thermal load, the method comprising:
- sensing a temperature at at least one location on the element (4),
- calculating a deformation of the element (4) caused by the thermal load as a function of the temperature sensed at the location, wherein the deformation is calculated using data from a computer generated model (180) of the element or by an emperical thermal deformation model ,
- compensating for the deformation of the element (4), **characterised in that** the element is a support frame (4) for supporting a further element (M1-M6).

22. A method according to claim 21, further comprising:
- modelling the element using a computer to generate the model (180) of the element (4) as a function of temperature.

23. A method according to claim 22, wherein the modelling includes at least one of finite element modelling and empirical modelling.

24. A method according to any of preceding claims 21-23, further comprising:
- outputting a control signal (cs), in response to the calculated deformation, wherein the control signal (cs) corrects for or takes into account the deformation.

25. A method according to claim 24, wherein the control signal (cs) is output to a further element (M1-M6) in the apparatus causing the further element (M1-M6) to correct for or take into account the deformation.

26. A method according to any of preceding claims 21-25, wherein the element (4) supports a plurality of moveable elements (M1-M6) disposed on the element (4) in a spaced relationship, the method comprising:
- adjusting the position of at least one of the plurality of moveable elements (M1-M6) in response to the sensed temperature.

27. A method according to any of preceding claims 21-26, the method comprising:
- disposing the at least one temperature sensor (10) on the element (4).

28. A computer readable storage medium storing a program which when run on a computer controls the computer to perform the method of any of claims 21-27.

## Patentansprüche

1. Lithografischer Apparat, der Folgendes umfasst: ein Element (4), das einer thermischen Belastung ausgesetzt wird, eine thermische Kompensations-Deformations-Einheit (10, 12, 14, 15) zum Kompensieren einer Deformation des Elements (4) in dem lithografischen Apparat, die durch die thermische Belastung hervorgerufen wird, wobei die thermische Kompensations-Deformations-Einheit (10, 12, 14, 15) Folgendes umfasst: wenigstens einen Temperatursensor (10), um eine Temperatur an wenigstens einer Stelle auf dem Element (4) abzutasten, eine Verarbeitungseinheit (12), um die Deformation des Elements (4), die durch die thermische Belastung hervorgerufen wird, als Funktion der Temperatur, die an der Stelle abgetastet wird, zu berechnen, wobei die Deformation berechnet wird, indem Daten aus einem computererzeugten Modell von dem Element (4) verwendet werden, sodass eine passende Korrektur erfolgen kann, oder für die Deformation in dem lithografischen Apparat berücksichtigt werden kann, **dadurch gekennzeichnet, dass** das Element (4) ein Stützrahmen ist, um ein weiteres Element (M1-M6) zu stützen bzw. zu tragen.

2. Apparat nach Anspruch 1, der weiter eine Modellierungseinheit (18) umfasst, um das Modell (180) des Elementes (4) zu erzeugen.

3. Apparat nach Anspruch 2, wobei die Modellierungseinheit (18) das Modell (180) verwendet, das durch eine Finite-Elemente-Modellierung oder durch eine experimentelle Passung erzeugt wird.

4. Apparat nach irgendeinem der vorangegangenen Ansprüche, wobei die thermische Deformations-Kompensations-Einheit (10, 12, 14, 15) weiter eine Steuerungseinheit (14) umfasst, so eingerichtet, um ein Steuerungssignal (cs) als Antwort auf die berechnete Information auszugeben, wobei das Steuerungssignal (cs) die Deformation korrigiert oder berücksichtigt.

5. Apparat nach Anspruch 4, wobei das Steuerungssignal (cs) an das weitere Element (M1 - M6) in dem Apparat ausgegeben wird, und bewirkt, dass das weitere Element (M1 - M6) die Deformation korrigiert oder berücksichtigt.

6. Apparat nach Anspruch 5, wobei das weitere Element (M1 - M6) auf dem Element (4) gestützt bzw. getragen wird.

7. Apparat nach irgendeinem der Ansprüche 4-6, wobei das Steuerungssignal (cs) die Deformation in einem Sollwert für die Steuerung des weiteren Elementes (M1 - M6) berücksichtigt.

8. Apparat nach irgendeinem der vorangegangen Ansprüche, der weiter eine Speichereinheit (16) umfasst, um das computererzeugte Modell (180) zu speichern.

9. Apparat nach irgendeinem der vorangegangenen Ansprüche, wobei der wenigstens eine Temperatursensor (10) direkt auf dem Element (4) angeordnet ist.

10. Apparat nach Anspruch 9, wobei der wenigstens eine Temperatursensor (10) auf wenigstens einer der Innenseite und Außenseite des Elementes (4) angeordnet ist.

11. Apparat nach Anspruch 1, wobei der Stützrahmen (4) wenigstens einer aus dem folgenden ist: ein Quellen-Rahmen ist, um eine Strahlungsquelle (SO) zu stützen bzw. zu tragen, ein Beleuchtungs-Einrichtungs-Rahmen, um ein Beleuchtungssystem (IL) zu stützen bzw. zu tragen, ein Bemusterungsmittel (MA)-Transportrahmen, um das Bemusterungsmittel zu stützen bzw. zu tragen, ein Projektionssystem-Stützrahmen, um ein Projektionssystem (PL) zu stützen bzw. zu tragen, ein erster Referenz-Stützrahmen (MF), um wenigstens entweder den Projektionssystem-Stützrahmen oder ein Messsystem zu stützen bzw. zu tragen, ein zweiter Referenz-Stützrahmen (BF), um den ersten Referenz-Stützrahmen zu stützen bzw. zu tragen, und ein Substrat-Stützrahmen, um ein Substrat (W) zu stützen bzw. zu tragen.

12. Apparat nach Anspruch 1, wobei wenigstens einer des ersten Referenz-Stützrahmens (MF) und des zweiten Referenz-Stützrahmens (BF) wenigstens entweder aus Invar oder Aluminium hergestellt wird.

13. Apparat nach irgendeinem der vorangegangenen Ansprüche 1-10, wobei das weitere Element (M1- M6) wenigstens eines von optischen Elementen (M1- M6) ist, und ein Element in einem Messsystem (IF) umfasst wird.

14. Apparat nach Anspruch 1 oder Anspruch 10, wobei das weitere Element (M1- M6) ein bewegliches optisches Element ist, das auf dem Stützrahmen gestützt bzw. getragen wird, und das das Steuerungssignal (cs) bewirkt, dass die Position des weiteren beweglichen optischen Elementes so eingestellt wird, um die Deformation des Elementes zu kompensieren, und zwar als Antwort auf die wenigstens eine Temperatur, die durch den wenigstens einen Sensor (10) abgetastet wird.

15. Apparat nach Anspruch 14, wobei wenigstens ein Temperatursensor (10) direkt auf dem Stützrahmen (4) und dem optischen Element (M1 - M6) angebracht ist, wobei die Position des optischen Elementes (M1 - M6) durch die Temperaturen bestimmt wird, die von den Temperatursensoren (10) abgetastet werden, der auf dem Stützrahmen (4) und dem optischen Element (M1- M6) angebracht ist.

16. Apparat nach irgendeinem der vorangegangenen Ansprüche, wobei die Verarbeitungseinheit (12), die auf dem Sensor (10) antwortet, ein Deformationssignal (ds) bereitstellt, das auf die Deformation hinweist, wobei die Verarbeitungseinheit (12) das Deformationssignal (ds) auf der Basis von Deformationsdaten und der abgetasteten Temperatur ableitet, wobei die Deformationsdaten aus dem Modell (180) abgeleitet werden, und die Deformation des Rahmens (4) als eine Funktion der Temperatur an der wenigstens einen Stelle darstellt.

17. Apparat nach irgendeinem der vorangegangenen Ansprüche 11-16, wobei der Projektionssystem-Stützrahmen (4) eine Vielzahl von optischen Elementen (M1 - M6) hält bzw. trägt, einschließlich wenigstens eines beweglichen optischen Elementes, wobei die Vielzahl von optischen Elementen (M1 - M6) in dem Rahmen (4) in einer beabstandeten Beziehung angebracht sind, wobei die thermische Deformations-Kompensations-Einheit (10, 12, 14, 15) eine Einstell- bzw. Justier-Einheit (15) umfasst, um die Position von wenigstens einer der Vielzahl von beweglichen Elementen (M1- M6) als Antwort auf die abgetastete Temperatur einzustellen.

18. Apparat nach irgendeinem der vorangegangenen Ansprüche, der Folgendes umfasst: wenigstens eines aus dem folgenden: ein Beleuchtungssystem (IL), um einen Projektionsstrahl von Strahlung bereitzustellen, eine Stützstruktur (MT) zum Unterstützen von Bemusterungsmitteln (MA), wobei das Bemusterungsmittel (MA) dazu dient, dem Projektionsstrahl ein Muster in seinem Querschnitt mitzugeben, einen Substrattisch (WT), um ein Substrat (W) zu stützen bzw. zu tragen, und ein Projektionssystem (PS), um den bemusterten Strahl auf einen Zielabschnitt des Substrates (W) zu projizieren.

19. Apparat nach irgendeinem der vorangegangenen Ansprüche, wobei die thermische Kompensations-Deformations-Einheit (10, 12, 14, 15) einen thermischen Effekt auf einer Struktur des Elementes (4) kompensiert.

20. Apparat nach irgendeinem der vorangegangenen Ansprüche, wobei der wenigstens eine Temperatursensor (10) an Stellen (s) angeordnet ist, wo die Struktur des Elementes (4) eine hohe Festigkeit aufweist.

21. Verfahren zum Kompensieren von thermischen Deformationen bei einem lithografischen Apparat, wobei der lithografische Apparat ein Element (4) umfasst, das einer thermischen Belastung ausgesetzt wird, wobei das Verfahren Folgendes umfasst:
- es wird eine Temperatur an wenigstens einer Stelle auf dem Element (4),
- es wird eine Deformation des Elementes (4), die durch die thermische Belastung hervorgerufen wird, als eine Funktion der Temperatur berechnet, die an der Stelle abgetastet wird, wobei die Deformation berechnet wird, indem Daten von einem computererzeugten Modell (180) des Elementes oder durch ein empirisches thermisches Deformationsmodell verwendet wird,
- es wird die Deformation des Elementes (4) berechnet, **dadurch gekennzeichnet, dass** das Element einen Stützrahmen (4) zum Stützen bzw. Tragen eines weiteren Elementes (M1- M6) ist.

22. Verfahren nach Anspruch 21, das weiter Folgendes umfasst:
- es wird das Element moduliert, wobei ein Computer verwendet wird, um das Modell (180) des Elementes (4) als eine Funktion der Temperatur zu erzeugen.

23. Verfahren nach Anspruch 22, wobei die Modellierung wenigstens entweder eine Finite-Elemente-Modellierung oder eine empirische Modellierung beinhaltet.

24. Verfahren nach irgendeinem der vorangegangenen Ansprüche 21 - 23, welches weiter Folgendes umfasst:
- es wird ein Steuerungssignal (cs) als Antwort auf die berechnete Deformation ausgegeben, wobei das Steuerungssignal (cs) die Deformation korrigiert oder berücksichtigt.

25. Verfahren nach Anspruch 24, wobei das Steuerungssignal (cs) an ein weiteres Element (M1 - M6) in dem Apparat ausgegeben wird, und wobei bewirkt wird, dass das weitere Element (M1 - M6) die Deformation berechnet oder berücksichtigt.

26. Verfahren nach irgendeinem der vorangegangenen Ansprüche 21 - 25, wobei das Element (4) eine Vielzahl von beweglichen Elementen (M1 - M6) hält bzw. trägt, die auf dem Element (4) in einer beabstandeten Beziehung angebracht sind, wobei das Verfahren Folgendes umfasst:
- es wird die Position von wenigstens einer der Vielzahl von beweglichen Elementen (M1- M6) als Antwort auf die abgetastete Temperatur eingestellt bzw. justiert.

27. Verfahren nach irgendeinem der vorangegangenen Ansprüche 21 - 26, wobei das Verfahren Folgendes umfasst:
- es wird der wenigstens eine Temperatursensor (10) auf dem Element (4) angeordnet.

28. Computerlesbares Speichermedium, das ein Programm speichert, das, wenn es auf einem Computer läuft, den Computer steuert, um das Verfahren irgendeiner der Ansprüche 21-27 auszuführen.

## Revendications

1. Dispositif lithographique comprenant : un élément (4) soumis à une charge thermique, une unité de compensation de déformation thermique (10, 12, 14, 15) destinée à compenser dans le dispositif lithographique une déformation de l'élément (4) provoquée par la charge thermique, l'unité de compensation de déformation thermique (10, 12, 14, 15) comprenant : au moins un capteur de température (10) destiné à détecter une température au niveau d'au moins un emplacement sur l'élément (4), une unité de traitement (12) destinée à calculer la déformation de l'élément (4) provoquée par la charge thermique en fonction de la température détectée au niveau de l'emplacement, dans lequel la déformation est calculée à l'aide de données provenant d'un modèle généré par ordinateur de l'élément (4), de sorte qu'une correction appropriée peut être apportée ou prise en compte pour la déformation dans le dispositif lithographique, **caractérisé en ce que** l'élément (4) est un châssis de support destiné à supporter un élément supplémentaire (M1-M6).

2. Dispositif selon la revendication 1, comprenant une unité de modélisation (18) destinée à générer le modèle (180) de l'élément (4).

3. Dispositif selon la revendication 2, dans lequel l'unité de modélisation (18) utilise le modèle (180) généré par une modélisation d'élément fini ou par un ajustement expérimental.

4. Dispositif selon l'une quelconque des revendications précédentes, dans lequel l'unité de compensation de déformation thermique (10, 12, 14, 15) comprend en outre une unité de commande (14) agencée pour émettre un signal de commande (cs), en réponse à la déformation calculée, dans lequel le signal de contrôle (cs) corrige ou tient compte de la déformation.

5. Dispositif selon la revendication 4, dans lequel le signal de commande (cs) est émis vers l'élément supplémentaire (M1-M6) dans le dispositif, amenant l'élément supplémentaire (M1-M6) à corriger ou tenir compte de la déformation.

6. Dispositif selon la revendication 5, dans lequel l'élément supplémentaire (M1-M6) est supporté sur l'élément (4).

7. Dispositif selon l'une quelconque des revendications 4 à 6, dans lequel le signal de commande (cs) tient compte de la déformation dans un point de réglage pour la commande de l'élément supplémentaire (M1-M6).

8. Dispositif selon l'une quelconque des revendications précédentes, comprenant en outre une unité de stockage (16) destinée à stocker le modèle généré par ordinateur (180).

9. Dispositif selon l'une quelconque des revendications précédentes, dans lequel ledit au moins un capteur de température (10) est disposé directement sur l'élément (4).

10. Dispositif selon la revendication 9, dans lequel ledit au moins un capteur de température (10) est disposé sur au moins un d'un intérieur et d'un extérieur de l'élément (4).

11. Dispositif selon la revendication 1, dans lequel le châssis de support (4) est au moins un d'un châssis de source destiné à supporter une source de rayonnement (SO), un châssis d'illuminateur destiné à supporter un système d'illumination (IL), un châssis de support de moyens de modelage destiné à supporter des moyens de modelage (MA), un châssis de support de système de projection destiné à supporter un système de projection (PL), un premier châssis de support de référence (MF) destiné à supporter au moins un du châssis de support de système de projection et d'un système de mesure, un deuxième châssis de support de référence (BF) destiné à supporter le premier châssis de support de référence et un châssis de support de substrat destiné à supporter un substrat (W).

12. Dispositif selon la revendication 1, dans lequel au moins un du premier châssis de support de référence (MF) et du deuxième châssis de support de référence (BF) est composé d'au moins un de l'invar et de l'aluminium.

13. Dispositif selon l'une quelconque des revendications 1 à 10, dans lequel l'élément supplémentaire (M1-M6) est au moins un d'un élément optique (M1-M6) et d'un élément compris dans un système de mesure (IF).

14. Dispositif selon la revendication 1 ou la revendication 10, dans lequel l'élément supplémentaire (M1-M6) est un élément optique mobile supporté sur le châssis de support, et le signal de commande (cs) amène la position de l'élément optique mobile supplémentaire à être ajustée de manière à compenser la déformation de l'élément, en réponse à ladite au moins une température détectée par ledit au moins un capteur (10).

15. Dispositif selon la revendication 14, dans lequel au moins un capteur de température (10) est disposé directement sur le châssis de support (4) et l'élément optique (M1-M6), dans lequel la position de l'élément optique (M1-M6) est déterminée par les températures détectées par les capteurs de température (10) disposés sur le châssis de support (4) et l'élément optique (M1-M6).

16. Dispositif selon l'une quelconque des revendications précédentes, dans lequel l'unité de traitement (12), en réponse au capteur (10), fournit un signal de déformation (ds) indicateur de la déformation, dans lequel l'unité de traitement (12) dérive le signal de déformation (ds) sur la base de données de déformation et de la température détectée, dans lequel les données de déformation sont dérivées du modèle (180) et représentent la déformation du châssis (4) en fonction de la température au niveau dudit au moins un emplacement.

17. Dispositif selon l'une quelconque des revendications précédentes 11 à 16, dans lequel le châssis de support de système de projection (4) supporte une pluralité d'éléments optiques (M1-M6) comprenant au moins un élément optique mobile, la pluralité d'éléments optiques (M1-M6) étant disposée dans le châssis (4) dans une relation espacée, dans laquelle l'unité de compensation de déformation thermique (10, 12, 14, 15) comprend une unité d'ajustement (15) destinée à ajuster la position d'au moins un de la pluralité d'éléments mobiles (M1-M6) en réponse à la température détectée.

18. Dispositif selon l'une quelconque des revendications précédentes comprenant : au moins un d'un système d'illumination (IL) destiné à fournir un faisceau de projection de rayonnement, d'une structure de support (MT) destinée à supporter des moyens de modelage (MA), les moyens de modelage (MA) servant à communiquer le faisceau de projection avec un modèle dans sa section transversale, d'une table de substrat (WT) destinée à supporter un substrat (W) et d'un système de projection (PS) destiné à projeter le faisceau modelé sur une partie cible du substrat (W).

19. Dispositif selon une quelconque des revendications précédentes, dans lequel l'unité de déformation de compensation thermique (10, 12, 14, 15) compense un effet thermique sur une structure de l'élément (4).

20. Dispositif selon l'une quelconque des revendications précédentes, dans lequel ledit au moins un capteur de température (10) est placé au niveau d'emplacements où la structure de l'élément (4) présente une rigidité élevée.

21. Procédé de compensation de déformation thermique dans un dispositif lithographique, ledit dispositif lithographique comprenant un élément (4) soumis à une charge thermique, le procédé comprenant les étapes consistant à :
détecter une température au niveau d'au moins un emplacement sur l'élément (4),
calculer une déformation de l'élément (4) provoquée par la charge thermique en fonction de la température détectée au niveau de l'emplacement, dans lequel la déformation est calculée en utilisant les données provenant d'un modèle généré par ordinateur (180) de l'élément ou par un modèle de déformation thermique empirique ;
compenser la déformation de l'élément (4), **caractérisée en ce que** l'élément est un châssis de support (4) pour supporter un élément supplémentaire (M1-M6).

22. Procédé selon la revendication 21, comprenant en outre l'étape consistant à :
modéliser l'élément à l'aide d'un ordinateur pour générer le modèle (180) de l'élément (4) en fonction de la température.

23. Procédé selon la revendication 22, dans lequel la modélisation comprend au moins une de la modélisation d'élément fini et de la modélisation empirique.

24. Procédé selon l'une quelconque des revendications 21 à 23, comprenant en outre l'étape consistant à :
émettre un signal de commande (cs), en réponse à la déformation calculée, où le signal de commande (cs) corrige ou tient compte de la déformation.

25. Procédé selon la revendication 24, dans lequel le signal de commande (cs) est émis vers un élément supplémentaire (M1-M6) dans le dispositif, amenant l'élément supplémentaire (M1-M6) à corriger ou tenir compte de la déformation.

26. Procédé selon l'une quelconque des revendications précédentes 21 à 25, dans lequel l'élément (4) supporte une pluralité d'éléments mobiles (M1-M6) disposés sur l'élément (4) dans une relation espacée, le procédé comprenant l'étape consistant à :
ajuster la position d'au moins un de la pluralité d'éléments mobiles (M1-M6) en réponse à la température détectée.

27. Procédé selon l'une quelconque des revendications 21 à 26, le procédé comprenant l'étape consistant à :
disposer ledit au moins un capteur de température (10) sur l'élément (4).

28. Support de stockage lisible par ordinateur stockant un programme qui, lorsqu'il est exécuté sur un ordinateur, commande l'ordinateur pour réaliser le procédé selon l'une quelconque des revendications 21 à 27.
